# EUROPÄISCHE PATENTANMELDUNG

(11) **EP 2 111 093 A2**
(43) Veröffentlichungstag der Anmeldung: **21.10.2009**
(21) Anmeldenummer: 09154946.9
(22) Anmeldetag: 12.03.2009
(51) Int. Cl.: H05K 13/04

(54) **Verfahren zum Bestücken von Substraten und Bestückautomat**

(30) Priorität: 16.04.2008 DE 102008019101
(71) Anmelder: Siemens Electronics Assembly Systems GmbH & Co. KG, 81379 München (DE)
(72) Erfinder: Mehdianpour, Mohammad, 81829, München (DE); Müller, Werner, 83607, Holzkirchen (DE)
(74) Vertreter: Maier, Daniel Oliver

(57) **Zusammenfassung**

Das erfindungsgemäße Verfahren zum Bestücken von Substraten (2) mit Bauelementen (3) ist für einen Bestückautomaten (1) vorgesehen, welcher einen Maschinengrundkörper (16), ein Positioniersystem (7) zur Aufnahme mindestens eines Bestückkopfs (6), welches am Maschinengrundkörper (16) angeordnet ist, einen ersten Bestückkopf (6) zum Handhaben der Bauelemente (3), welcher an dem Positioniersystem (7) in einer x-Richtung verfahrbar angeordnet ist, sowie mindestens zwei Halteeinrichtungen (8) aufweist, welche jeweils zum Halten eines der Bauelemente (3) an dem ersten Bestückkopf (6) in einer Ebene parallel zur Ebene des Substrats (2) angeordnet sind. Das Verfahren selbst zeichnet sich dadurch aus, dass mindestens zwei Bauelemente (3) auf vordefinierte Bestückpositionen des Substrats (2) bestückt werden, wobei während der Positionierung der mindestens zwei Bauelemente (3) das Substrat (2) sowie das Positioniersystem (7) relativ zum Maschinengrundkörper (16) ruhen und wobei die Bestückpositionen der mindestens zwei Bauelemente (3) einen unterschiedlichen Abstand zu einer senkrechten Projektion der Verfahrachse des Bestückkopfs (6) auf das Substrat (2) aufweisen. Hieraus ergibt sich der Vorteil, dass das Substrat (2) streifenweise mit Bauelementen (3) bestückt werden kann, wobei während der Bestückung eines Streifens weder das Substrat (2) noch das Positioniersystem (7) bewegt werden müssen. Alle zur Positionierung erforderlichen Bewegungen werden ausschließlich durch den Bestückkopf (6) ausgeführt. Aufgrund der dabei deutlich geringeren bewegten Masse kann das Schwingungsverhalten und damit die Bestückgenauigkeit deutlich verbessert werden.

## Beschreibung

Die Erfindung betrifft ein Verfahren zum Bestücken von Substraten mit Bauelementen sowie einen Bestückautomaten zur Durchführung des Verfahrens.

In der Bestücktechnik werden mit Hilfe sogenannter Bestückautomaten Substrate, beispielsweise Leiterplatten, mit Bauelementen verschiedenster Art bestückt. Hierzu werden die Bauelemente durch am Bestückautomaten angeordnete Zuführeinrichtungen an definierten Abholpositionen bereitgestellt. Ein durch ein Positioniersystem verfahrbarer Bestückkopf des Bestückautomaten holt die Bauelemente an den Abholpositionen ab und transferiert sie zu einem Bestückbereich des Bestückautomaten, wo sie auf bereitgestellten Substraten positioniert werden. Zu bestückende Substrate werden über eine Transporteinrichtung dem Bestückbereich zugeführt, fertig bestückte Substrate werden über diese Transporteinrichtung wieder aus dem Bestückbereich heraustransportiert. Ein derartiger Bestückautomat ist beispielsweise aus der Patentschrift DE 10336609 B3 bekannt.

Ferner ist aus der Offenlegungsschrift DE 102 35 471 A1 eine Vorrichtung zum Bestücken von Substraten in der sogenannten "Split-Axes"-Konfiguration bekannt, bei der ein Bestückkopf mit mehreren nebeneinander angeordneten Halteeinrichtungen ausschließlich entlang einer x-Richtung und das Substrat ausschließlich entlang einer y-Richtung bewegbar sind.

Es ist Aufgabe der vorliegenden Erfindung ein Verfahren zum Bestücken von Substraten mit Bauelementen sowie einen Bestückautomaten zu liefern, durch welche die Bestückleistung erhöht werden kann.

Diese Aufgabe wird durch das Verfahren sowie den Bestückautomaten gemäß den unabhängigen Ansprüchen gelöst. Vorteilhafte Ausgestaltungen sind Gegenstand der abhängigen Ansprüche.

Das erfindungsgemäße Verfahren zum Bestücken von Substraten mit Bauelementen ist auf einen Bestückautomaten anwendbar, welcher einen Maschinengrundkörper, ein Positioniersystem zur Aufnahme mindestens eines Bestückkopfs, welches am Maschinengrundkörper angeordnet ist, einen ersten Bestückkopf zum Handhaben der Bauelemente, welcher an dem Positioniersystem in einer x-Richtung verfahrbar angeordnet ist, sowie mindestens zwei Halteeinrichtungen umfasst, welche jeweils zum Halten eines der Bauelemente an dem ersten Bestückkopf in einer Ebene parallel zur Ebene des Substrats angeordnet sind. Das Verfahren zeichnet sich dadurch aus, dass mindestens zwei Bauelemente auf vordefinierte Bestückpositionen des Substrats bestückt werden, wobei während der Positionierung der mindestens zwei Bauelemente das Substrat sowie das Positioniersystem relativ zum Maschinengrundkörper ruhen und wobei die Bestückpositionen der mindestens zwei Bauelemente sich innerhalb eines zu bestückenden Streifens des Substrats befinden und einen unterschiedlichen Abstand zu einer senkrechten Projektion der Verfahrachse des Bestückkopfs auf das Substrat aufweisen.

Diese Vorgehensweise, bei der ein Substrat "streifenweise" bestückt wird, hat den Vorteil, dass die Positionierung der einzelnen Bauelemente eines Streifens durch Positionierbewegungen des Bestückkopfs erfolgt - weder das Substrat noch das Positioniersystem selbst müssen dabei bewegt werden. Indem lediglich der Bestückkopf (und damit eine deutlich geringere Masse) bewegt wird, lassen sich Schwingungen, welche üblicherweise aus den Beschleunigungen des Positioniersystems resultieren und auf den Maschinengrundkörper einwirken, deutlich reduzieren. Die Bestückgenauigkeit kann dadurch deutlich erhöht werden. Unter der "streifenweisen Bestückung" ist dabei zu verstehen, dass ein Streifen des Substrats, d.h. ein Bereich mit einer von Null verschiedenen Breite, bei ruhendem Substrat und festgehaltenem Positioniersystem mittels eines geeigneten Bestückkopfs bestückt werden kann.

Hieraus ergibt sich der Vorteil, dass nicht jede Bestückposition auf dem Substrat mittels einer Relativbewegung zwischen dem Positioniersystem und dem Substrat einzeln positioniert werden muss: Vielmehr ist es ausreichend, das Positioniersystem sowie das Substrat derart relativ zueinander zu positionieren, dass allein durch die Positionierbewegungen des Bestückkopfs mehrere Bestückpositionen auf dem Substrat mit Bauelementen bestückbar sind. Indem Verfahrbewegungen des Positioniersystems vermieden werden, können Schwingungen des Positioniersystems und damit des Bestückautomaten unterbunden werden, so dass die Bestückgenauigkeit dadurch deutlich verbessert wird.

Gegenüber den herkömmlichen Split-Axes Bestückverfahren, bei denen das Substrat für die Positionierung eines jeden Bauelements verfahren werden muss, resultiert hieraus der Vorteil, dass beim Bestücken eines Streifens das Substrat ruht, so dass bereits bestückte Bauelemente nicht durch die Verfahrbewegungen des Substrats verrutschen können.

In einer vorteilhaften Ausgestaltung des Bestückverfahrens bleibt das Substrat auch nach dem Bestücken eines Streifens des Substrats mit Bauelementen relativ zum Maschinengrundkörper fixiert, während das Positioniersystem in einer y-Richtung um eine definierte Länge weitergefahren wird, so dass ein weiterer Streifen des Substrats bestückt werden kann.

Indem das Substrat während des gesamten Bestückprozesses ruht, können bereits bestückte Bauelemente nicht durch eine Verfahrbewegung des Substrats verrutschen. Darüber hinaus ist das Verfahren mittels der gängigen Bestückautomaten, welche über ein x-/y-Positioniersystem verfügen, bei dem der Bestückkopf sowohl in der x-Richtung als auch in der y-Richtung verfahrbar ist, durchführbar.

In einer weiteren vorteilhaften Ausgestaltung des Bestückverfahrens, bei der der Bestückautomat ferner eine Substrat-Transporteinrichtung umfasst, wird nach dem Bestücken eines Streifens des Substrats das Substrat mit Bauelementen das Substrat mittels der Substrat-Transporteinrichtung in einer y-Richtung um eine definierte Länge weitergefahren, während das Positioniersystem relativ zum Maschinengrundkörper fixiert bleibt, so dass ein weiterer Streifen des Substrats bestückt werden kann.

Da die zweite Linearachse zur Positionierung des Bestückkopfs relativ zu dem zu bestückenden Streifen des Substrats durch die Substrat-Transporteinrichtung realisiert ist, kann das Positioniersystem als feststehende Führung mit nur einer Linearachse zum ausschließlichen Verfahren des Bestückkopfs in der x-Richtung ausgebildet werden. Damit lassen sich störende Schwingungen, welche aus den Beschleunigungen des Positioniersystems resultieren und auf den Maschinengrundkörper einwirken würden, deutlich reduzieren. Die Bestückgenauigkeit kann dadurch deutlich erhöht werden.

Um ein Verrutschen der bereits bestückten Bauelemente beim Verfahren des Substrats zu vermeiden, kann das Substrat mit reduzierter Beschleunigung verfahren werden. Die Auswirkungen auf die Bestückleistung sind dabei gering, da ein Verfahren des Substrats nur bei einem Wechsel von einem zu bestückenden Streifen zum nächsten, nicht aber zur Positionierung eines jeden Bauelements, erforderlich ist.

Dieses Verfahren ist selbstverständlich auch mit einem Bestückautomaten mit x-/y-Positioniersystem durchführbar, wobei in diesem Fall das Positioniersystem relativ zum Maschinengrundkörper ruht.

In einer weiteren vorteilhaften Ausgestaltung des Bestückverfahrens werden die Bauelemente mittels Zuführeinrichtungen des Bestückautomaten bereitgestellt und vor dem Bestücken des Substrats durch den Bestückkopf von den Zuführeinrichtungen abgeholt.

Mit Hilfe der Zuführeinrichtungen wird auch die Bereitstellung der Bauelemente automatisiert.

In einer weiteren vorteilhaften Ausgestaltung des Bestückverfahrens ist an dem Positioniersystem ein weiterer Bestückkopf angeordnet. Dabei ist jedem der beiden Bestückköpfe eine eigene Antriebseinheit zugeordnet, mittels derer die beiden Bestückköpfe unabhängig voneinander am Positioniersystem verfahren werden können.

Mit Hilfe des weiteren Bestückkopfs, welcher an demselben Positioniersystem wie der erste Bestückkopf linear verfahrbar angeordnet ist, kann die Anzahl der für die Bestückung zur Verfügung stehenden Halteeinrichtungen vergrößert werden., wodurch sich die Bestückleistung des Bestückautomaten weiter erhöht, ohne dass hierfür ein weiteres Positioniersystem erforderlich wäre.

In einer weiteren vorteilhaften Ausgestaltung des Bestückverfahrens sind die beiden Bestückköpfe an verschiedenen Seiten des Positioniersystems angeordnet. Das Substrat wird dabei von einem der beiden Bestückköpfe streifenweise mit Bauelementen bestückt, während der andere der beiden Bestückkopfe Bauelemente von den Zuführeinrichtungen abholt.

Indem die beiden Bestückköpfe an verschiedenen Längsseiten des Positioniersystems angeordnet sind, können sie weitestgehend unabhängig voneinander agieren. Beispielsweise ist einer der Bestückköpfe an der Vorderseite des Positioniersystems parallel zu einer Längserstreckung verfahrbar angeordnet, während der andere Bestückkopf parallel dazu an der Rückseite des Positioniersystems verfahrbar angeordnet ist.

Eine mögliche Betriebsweise ist dabei ein wechselseitiges Bestücken des Substrats, bei dem die beiden Bestückköpfe abwechselnd Bauelemente abholen bzw. bestücken, wobei jeder der Bestückköpfe einen eigenen Streifen des Substrats bestückt und von eigenen ihm zugeordneten Zuführeinrichtungen Bauelemente abholt. Durch die Anordnung der beiden Bestückköpfe an verschiedenen Seiten des Positioniersystems kann die Flexibilität des Bestückautomaten bei gleichzeitig deutlich höherer Bestückleistung erhöht werden.

Es ist jedoch ebenso möglich, dass die beiden Bestückköpfe nicht abwechselnd, sondern gemeinsam jeweils einen Streifen des Substrats bestücken und anschließend gemeinsam Bauelemente von den dem jeweiligen Bestückkopf zugeordneten Zuführeinrichtungen abholen. Ferner ist es möglich, dass die beiden Köpfe völlig unabhängig voneinander einen ihnen jeweils zugeordneten Streifen des Substrats bestücken.

In einer weiteren vorteilhaften Ausgestaltung des Verfahrens wird der Bestückkopf derart über den Zuführeinrichtungen positioniert, dass mittels der mindestens zwei Halteeinrichtungen des Bestückkopfs mehrere Bauelemente gleichzeitig abgeholt werden.

Um mehrere Bauelemente gleichzeitig abholen zu können ist es erforderlich, dass der Abstand der mindestens zwei Halteeinrichtungen dem Abstand der Abholpositionen der gleichzeitig abzuholenden Bauelemente entspricht. Dadurch kann die Effizienz des Abholvorgangs deutlich erhöht werden.

In einer weiteren vorteilhaften Ausgestaltung des Verfahrens ist der Bestückautomat an ein Transportsystem zur Versorgung des Bestückautomaten mit Substraten angeschlossen, wobei ein fertig bestücktes Substrat an das Transportsystem übergeben wird.

Indem der Bestückautomat an ein Transportsystem angeschlossen wird, kann auch die Bereitstellung der zu bestückenden Substrate sowie der Weitertransport der vollständig oder teilweise bestückten Substrate automatisiert werden, wodurch sich die Bestückleistung des Bestückautomaten weiter erhöht.

Der erfindungsgemäße Bestückautomat zur Durchführung des Verfahrens umfasst einen Maschinengrundkörper, ein Positioniersystem zur Aufnahme mindestens eines Bestückkopfs, welches am Maschinengrundkörper angeordnet ist, einen ersten Bestückkopf zum Handhaben der Bauelemente, welcher an dem Positioniersystem in einer x-Richtung verfahrbar angeordnet ist, sowie mindestens zwei Halteeinrichtungen, welche zum Halten der Bauelemente an dem ersten Bestückkopf in einer Ebene parallel zu einer Ebene des Substrats angeordnet sind, wobei ein relativ zum Maschinengrundkörper ruhendes Substrat bei einem relativ zum Maschinengrundkörper festgehaltenem Positioniersystem zumindest streifenweise bestückbar ist.

Unter der Formulierung "streifenweise bestückbar" ist dabei zu verstehen, dass ein Streifen des Substrats, d.h. ein Bereich mit einer von Null verschiedenen Breite bei ruhendem Substrat und festgehaltenem Positioniersystem bestückt werden kann. Dies wird ermöglicht, indem einerseits der Bestückkopf entlang des Positioniersystems linear in x-Richtung verfahren werden kann, und andererseits die am Bestückkopf angeordneten Halteeinrichtungen quer zur Verfahrrichtung des Bestückkopfs verstellbar sind. Das Positioniersystem kann dabei beliebig ausgebildet sein, für den Vorgang des streifenweisen Bestückens wird es jedoch relativ zum Maschinengrundkörper fixiert oder festgehalten.

Hieraus ergibt sich der Vorteil, dass nicht jede Bestückposition auf dem Substrat mittels einer Relativbewegung zwischen dem Positioniersystem und dem Substrat einzeln positioniert werden muss: Vielmehr ist es ausreichend, das Positioniersystem sowie das Substrat derart relativ zueinander zu positionieren, dass allein durch die lineare Verfahrbewegung des Bestückkopfs sowie die Verstellmöglichkeit einzelner Halteeinrichtungen quer zur Verfahrbewegung des Bestückkopfs mehrere Bestückpositionen auf dem Substrat mit Bauelementen bestückbar sind. Durch die Vermeidung von Positionierbewegungen des Positioniersystems können Schwingungen des Positioniersystems und damit des Bestückautomaten vermieden werden, die Bestückgenauigkeit wird dadurch deutlich verbessert.

In einer vorteilhaften Ausgestaltung weist der Bestückautomat ferner eine Steuereinrichtung zur Steuerung des Bestückkopfs auf.

Durch die Verwendung der Steuereinrichtung ergibt sich der Vorteil, dass der Bestückungsvorgang hinsichtlich der Verfahrwege beim Bestücken der Substrate verbessert werden kann. Ferner kann auch bei unvorhergesehenen Ereignissen unmittelbar automatisch korrigierend in den Bestückungsvorgang eingegriffen werden. Die Bestückleistung wird dadurch verbessert.

In einer weiteren vorteilhaften Ausgestaltung des Bestückautomaten ist das Positioniersystem als feststehendes Portal ausgebildet, welches fest mit dem Grundkörper verbunden ist.

Da es für das Prinzip des streifenweisen Bestückens nicht explizit notwendig ist, das Positioniersystem verfahrbar auszubilden, kann eine einfache Ausführungsform, bei der das Positioniersystem als feststehendes Portal oder Führungselement ausgebildet ist, als kostengünstige Realisierungsmöglichkeit gewählt werden. Das Positioniersystem ist damit gegenüber dem Maschinengrundkörper nicht mehr verfahrbar. Es handelt sich damit um eine klassische Split-Axes Ausführung eines Bestückautomaten, bei der es zur Bestückung eines weiteren Streifens des Substrats dann jedoch zwingend erforderlich ist, dass das Substrat in einer Richtung quer, vorzugsweise orthogonal, zur Verfahrrichtung des Bestückkopfs verfahrbar auszuführen.

In einer weiteren vorteilhaften Ausgestaltung des Bestückautomaten ist mindestens ein weiterer Bestückkopf an dem Positioniersystem in x-Richtung verfahrbar angeordnet.

Durch die Verwendung eines weiteren Bestückkopfs kann die Anzahl an nutzbaren Halteelementen erhöht werden, ohne dass hierfür ein weiteres Positioniersystem erforderlich wäre. Damit kann ohne großen konstruktiven Aufwand die Bestückleistung deutlich erhöht werden.

In einer weiteren vorteilhaften Ausgestaltung des Bestückautomaten sind die mindestens zwei Bestückköpfe an unterschiedlichen Führungselementen des Positioniersystems anordenbar.

Indem die beiden Bestückköpfe an unterschiedlichen Führungselementen des Positioniersystems parallel zueinander angeordnet sind, können sie weitestgehend unabhängig voneinander agieren. Beispielsweise können die beiden Bestückköpfe an verschiedenen, einander gegenüberliegenden Längsseiten des Positioniersystems angeordnet sein. Die den beiden Bestückköpfen jeweils zugeordneten Streifen des Substrats, die mittels der beiden Bestückköpfe erreichbar sind, können dabei völlig unabhängig voneinander bestückt werden. Durch diese Anordnung der beiden Bestückköpfe kann die Flexibilität des Bestückautomaten bei gleichzeitig deutlich höherer Bestückleistung erhöht werden.

Eine mögliche Betriebsweise ist dabei ein wechselseitiges Bestücken des Substrats, bei dem die beiden Bestückköpfe abwechselnd Bauelemente abholen bzw. bestücken, wobei jeder der Bestückköpfe einen eigenen Streifen des Substrats bestückt und von eigenen ihm zugeordneten Zuführeinrichtungen Bauelemente abholt. Es ist jedoch ebenso möglich, dass die beiden Bestückköpfe nicht abwechselnd, sondern gemeinsam jeweils einen Streifen des Substrats bestücken und anschließend gemeinsam Bauelemente von den dem jeweiligen Bestückkopf zugeordneten Zuführeinrichtungen abholen. Ferner ist es möglich, dass die beiden Köpfe völlig unabhängig voneinander einen ihnen jeweils zugeordneten Streifen des Substrats bestücken.

In einer weiteren vorteilhaften Ausgestaltung des Bestückautomaten sind mehrere Bestückköpfe an derselben Seite des Positioniersystems anordenbar und weisen ein gemeinsames Führungselement auf.

Bei dieser Anordnung, bei der mehrere Bestückköpfe auf derselben Längsseite des Positioniersystems verfahrbar angeordnet sind, besteht der Vorteil darin, dass die Bestückköpfe Führungs- und Antriebselemente gemeinsam nutzen können. Falls Linearmotoren verwendet werden kann beispielsweise die Magnetschiene von beiden Bestückköpfen gemeinsam genutzt werden, woraus Kostenvorteile erzielbar sind. Die beiden Bestückköpfe verfahren damit mehr oder weniger gemeinsam zwischen den Zuführeinrichtungen und den Bestückpositionen auf dem Substrat. Der relative Anteil der Verfahrzeiten zwischen den Zuführeinrichtungen und den Bestückpositionen kann durch die größere Anzahl an einsetzbaren Halteeinrichtungen reduziert werden, so dass sich die Bestückleistung hierdurch entsprechend erhöht.

In einer weiteren vorteilhaften Ausgestaltung des Bestückautomaten ist jedem der Bestückköpfe eine eigene Antriebseinheit zugeordnet, welche eine voneinander unabhängige Bewegung der Bestückköpfe am Positioniersystem ermöglicht.

Indem jedem Bestückkopf eine eigene Antriebseinheit zugeordnet ist, welche eine voneinander unabhängige Bewegung der Bestückköpfe am Positioniersystem ermöglicht, kann die Flexibilität des Bestückautomaten, beispielsweise hinsichtlich der Verfahrwege, der Bestückreihenfolge oder der Einteilung des Substrats in zu bestückende Streifen, deutlich erhöht werden.

In einer weiteren vorteilhaften Ausgestaltung des Bestückautomaten weist jede Halteeinrichtung einen eigenen, separat ansteuerbaren z-Antrieb auf, welcher eine Bewegung der jeweiligen Halteeinrichtung in einer z-Richtung senkrecht zur Ebene des Substrats ermöglicht.

Indem jede Halteeinrichtung einen eigenen, individuell ansteuerbaren z-Antrieb aufweist, können die Achsen der einzelnen Halteeinrichtungen bereits während des Verfahrens des jeweiligen Bestückkopfs in z-Richtung vorpositioniert werden. Durch diese Parallelisierung der Verfahrbewegung des Bestückkopfs einerseits mit der Zustellbewegung in z-Richtung andererseits kann die Bestückleistung weiter erhöht werden.

In einer weiteren vorteilhaften Ausgestaltung des Bestückautomaten ist jeder Halteeinrichtung ein eigener, separat ansteuerbarer Drehantrieb zugeordnet, welcher eine Drehbewegung der jeweiligen Halteeinrichtung um eine Achse senkrecht zur Ebene des Substrats ermöglicht.

Indem jeder Halteeinrichtung ein eigener, individuell ansteuerbaren Drehantrieb zugeordnet ist, kann bereits während des Verfahrens des jeweiligen Bestückkopfs oder auch während der Vorpositionierung der jeweiligen Halteeinrichtung in z-Richtung eine Korrektur der Winkellage des gehaltenen Bauelements um die z-Achse erfolgen, wodurch die Bestückleistung weiter erhöht werden kann.

In einer weiteren vorteilhaften Ausgestaltung des Bestückautomaten weist zumindest einer der Bestückköpfe eine zusätzliche Drehachse zum Drehen des Bestückkopfs auf, wobei die Drehachse senkrecht zur Ebene des Substrats orientiert ist, so dass mittels der mindestens zwei Halteeinrichtungen des Bestückkopfs Bewegungen in einer Ebene parallel zur Ebene des Substrats ausführbar sind.

Bei ruhendem Substrat und festgehaltenem Positioniersystem ist für die streifenweise Bestückung neben der Verfahrbewegung des Bestückkopfs entlang des Positioniersystems eine weitere Bewegungsmöglichkeit quer zur Verfahrbewegung des Bestückkopfs, vorzugsweise parallel zur Ebene des Substrats, nötig. Eine einfache zu realisierende Möglichkeit stellt dabei eine Drehachse für den Bestückkopf dar, welche senkrecht zur Ebene des Substrats orientiert ist. Damit kann der betreffende Bestückkopf in einer Ebene parallel zur Ebene des Substrats geschwenkt werden, so dass die Halteeinrichtungen durch eine Überlagerung mit der Verfahrbewegung des Bestückkopfs innerhalb eines Streifens mit der Breite des jeweiligen Schwenkkreises über dem Substrat positionierbar sind. Für diese Ausgestaltung kommen prinzipiell alle Bestückköpfe in Frage, deren Halteeinrichtungen in einer Ebene parallel zur Ebene des Substrats angeordnet und in z-Richtung orientiert sind.

In einer weiteren vorteilhaften Ausgestaltung des Bestückautomaten weist der Bestückkopf einen um die Drehachse drehbaren Rotor auf, an dem die mindestens zwei Halteeinrichtungen angeordnet sind.

Eine spezielle Ausführungsform des oben ausgeführten Bestückkopfs mit einer Schwenkachse ist ein horizontal drehender Rotationskopf mit einem um die senkrecht zur Substratebene orientierte Drehachse drehbaren Rotor, an dem die Halteeinrichtungen in z-Richtung verschieblich angeordnet sind. Durch eine Überlagerung der Verfahrbewegung des Bestückkopfs mit der Drehbewegung des Rotors ist es ebenso möglich, die Halteeinrichtungen innerhalb eines Streifens über dem Substrat zu positionieren. Die Breite des Streifens entspricht dabei der doppelten Breite des Abstands der Halteeinrichtungen zur Drehachse des Rotors.

Im Folgenden wird ein Ausführungsbeispiel des erfindungsgemäßen Bestückautomaten unter Bezug auf die beigefügten Figuren näher erläutert. Dabei zeigt:
- Figur 1: Eine schematische Darstellung eines Bestückautomaten mit beweglichem Portalarm im Grundriss,
- Figuren 2a und 2b: Schematische Darstellungen eines Bestückautomaten mit fixiertem Positioniersystem in Grund- und Aufriss,
- Figuren 3a bis 3c: Schematische Darstellungen verschiedener Konzepte für einen Bestückkopf zum streifenweisen Bestücken (z.B. Turret head mit n*z und n*dp; Matrix-Kopf mit Schwenkachse)

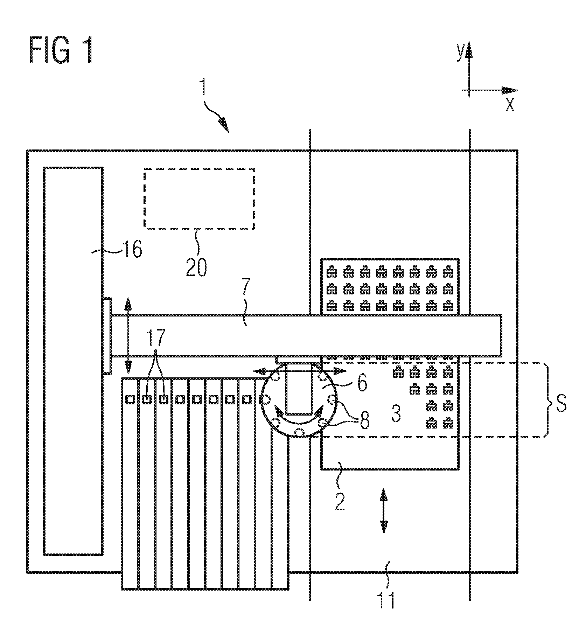

Figur 1 zeigt schematisch einen Bestückautomaten 1 zum Bestücken von Substraten 2 mit Bauelementen 3. Der Bestückautomat 1 umfasst einen Positioniersystem 7, welches sich in einer x-Richtung erstreckt und in einer y-Richtung verschiebbar an einem Maschinengrundkörper 16 angeordnet ist, wobei durch die x-Achse und die y-Achse ein orthogonales Bezugssystem gebildet wird. Am Positioniersystem 7, welches hier als einseitig gelagerter Portalarm dargestellt ist, ist ein Bestückkopf 6 in x-Richtung verfahrbar angeordnet. Der Bestückkopf 6 verfügt über eine Mehrzahl an Halteeinrichtungen 8 (gestrichelt dargestellt) zum Aufnehmen und Absetzen der Bauelemente 3. Weiterhin ist eine Substrat-Transporteinrichtung 11 zum Transport der Substrate 2 in y-Richtung vorgesehen. Seitlich der Substrat-Transporteinrichtung 11 sind Zuführvorrichtungen 5 in einem Abholbereich des Bestückautomaten 1 angeordnet, mittels derer die Bauelemente 3 an definierten Abholpositionen 17 bereitgestellt werden. Zur Steuerung des Bestückautomaten 1 ist ferner eine Steuereinrichtung 20 vorgesehen.

Zum Bestücken werden die Substrate 2 über die Substrat-Transporteinrichtung 11 in den Bestückbereich des Bestückautomaten 1 transportiert. Die von den Zuführvorrichtungen 5 an Abholpositionen bereitgestellten Bauelemente 3 werden von dem Bestückkopf 6 abgeholt und in den Bestückbereich des Bestückautomaten 1 transferiert, wo sie auf dem Substrat 2 positioniert werden. Mit Hilfe eines derart gestalteten Bestückautomaten 1 ist es möglich, ein Substrat 2 streifenweise zu bestücken, d.h. ein Streifen S des Substrats 2 wird mit Bauelementen 3 bestückt, während das Substrat 2 sowie auch das Positioniersystem 7 relativ zum Maschinengrundkörper 16 ruhen. Die Positionierung eines Bauelements 3 in einer x/y-Ebene oberhalb der Ebene des Substrats 2 erfolgt lediglich durch die lineare Verfahrbewegung des Bestückkopfs 6 am Portalarm sowie eine Dreh- oder Schwenkbewegung der jeweiligen Halteeinrichtungen 8 um eine Achse, welche senkrecht zur Ebene des Substrats 2 orientiert ist.

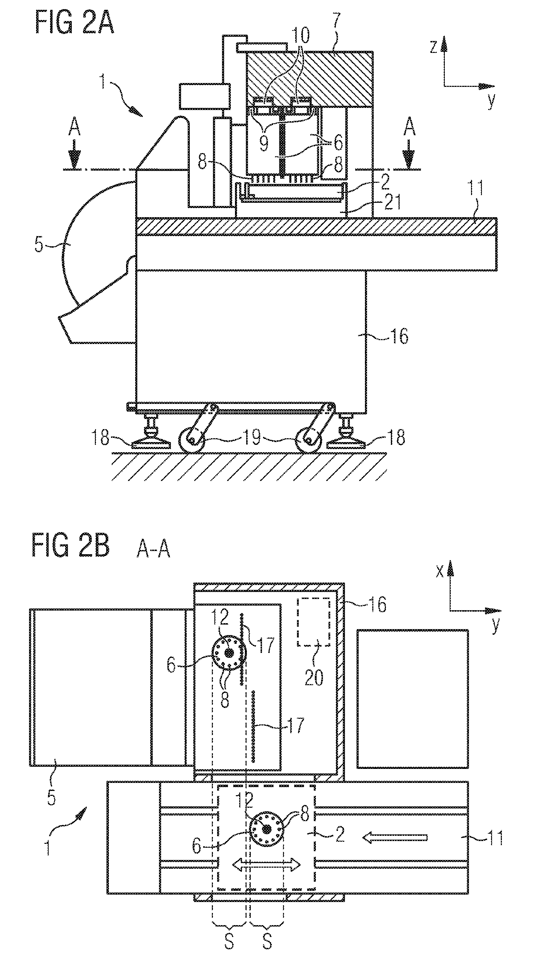

In den Figuren 2a und 2b ist eine weitere Ausführungsform eines Bestückautomaten 1 schematisch in Grund- und Aufriss dargestellt, wobei die Aufrissdarstellung in Figur 2b als Schnittdarstellung entlang der Schnittlinie A-A ausgeführt ist.

Der Bestückautomat 1 weist ein Positioniersystem 7 auf, an dem zwei Bestückköpfe 6 in einer x-Richtung verfahrbar angeordnet sind. Das Positioniersystem 7 selbst ist in diesem Fall nicht verfahrbar ausgebildet, sondern dient ausschließlich der linearen Führung der Bestückköpfe 6 und ist mit einem Maschinengrundkörper 16 des Bestückautomaten 1 fest verbunden. Da es sich bei der dargestellten Ausführungsform des Positioniersystems 7 um keinen beweglichen Positionierarm handelt, kann die Anordnung sehr steif ausgeführt werden, was bei den hohen dynamischen Anforderungen aufgrund der geringeren bewegten Masse zu einer reduzierten Schwingungsneigung und damit zu einer verbesserten Genauigkeit bei der Bestückung führt.

Ebenfalls fest mit dem Maschinengrundkörper 16 verbunden ist die Substrat-Transporteinrichtung 11, welche zum Transport eines Substrats 2 in einer y-Richtung vorgesehen ist. Hierzu weist die Substrat-Transporteinrichtung 11 einen Schlitten 21 auf, auf dem das Substrat 2 ortsfest fixiert werden kann. Der Schlitten verfügt über einen Antrieb (nicht dargestellt), mit dessen Hilfe der er gemeinsam mit dem fixierten Substrat 2 in der y-Richtung exakt positioniert werden kann. Ist eine hohe Positioniergenauigkeit gefordert kommen für den Antrieb beispielsweise Linearantriebe in Betracht. Andernfalls können auch alternative Antriebsformen, beispielsweise Spindelantriebe, eingesetzt werden. Mit Hilfe von Zuführeinrichtungen 5 können Bauelemente 3 (siehe Figur 1) an definierten Abholpositionen 17 bereitgestellt und von den Bestückköpfen 6 abgeholt werden. Ferner weist der Bestückautomat 1 noch Standfüße 18 zum sicheren Aufstellen innerhalb eines Fertigungsbereichs, sowie aktivierbare Transportrollen 19 auf, welche einen Standortwechsel des Bestückautomaten 1 - beispielsweise zu Wartungs-, Reparatur- oder Rüstzwecken, erleichtern.

Zum Verfahren der Bestückköpfe 6 in x-Richtung sind jeweils Führungselemente 9 sowie Antriebseinheiten 10 zwischen dem feststehenden Positioniersystem 7 und dem jeweiligen Bestückkopf 6 vorgesehen. Die beiden Bestückköpfe 6 sind hier als Rotationsköpfe ausgebildet, welche eine Drehachse 12 sowie einen um diese Drehachse 12 drehbaren Rotor 13 aufweisen, an dem jeweils mehrere Halteeinrichtungen 8 angeordnet sind. Die Drehachse 12 ist dabei in einer z-Richtung, senkrecht zu einer Ebene des Substrats 2, orientiert, welche durch die zu bestückende Substratoberfläche bestimmt wird. Die Halteeinrichtungen 8 sind in einer Ebene parallel zur Ebene des Substrats 2 am Rotor angeordnet und in der z-Richtung verschiebbar, so dass Bauelemente 3 an den Abholpositionen 17 aufgenommen und an ihren jeweiligen vordefinierten Bestückpositionen auf dem Substrat 2 abgesetzt werden können.

Durch die Rotationsbewegung der am Rotor 13 angeordneten Halterichtungen 8 entsteht relativ zum Substrat 2 eine zusätzliche y-Achse, mit deren Hilfe die Positionierung in y-Richtung realisiert wird. Damit ist es möglich, einen Streifen S auf dem Substrat 2, welcher sich in x-Richtung erstreckt und in y-Richtung ungefähr die Breite des Bestückkopfs 6 aufweist, mit Bauelementen 3 zu bestücken, ohne dabei das Positioniersystem 7 oder das Substrat 2 zum Zweck der Positionierung verfahren zu müssen.

Die beiden Bestückköpfe sind im vorliegenden Fall am Positioniersystem 7 hängend dargestellt. Es ist jedoch ebenso möglich, die Bestückköpfe 6 seitlich am Positioniersystem 7 anzuordnen. Ferner ist es ebenso möglich, die Bestückköpfe 6 als Zeilenköpfe auszubilden, bei denen die Halteeinrichtungen 8 in einer Reihe parallel zur Ebene des Substrats 2 angeordnet sind. In diesem Fall müssten die Zeilenköpfe dann jedoch eine zusätzliche Schwenk- oder Drehachse 12 aufweisen, welche ebenfalls senkrecht zur Substratebene orientiert ist und eine Bewegung der Halteeinrichtungen 8 in einer weiteren Ebene parallel zur Substratebene ermöglicht.

Der dargestellte Bestückautomat 1 kann sowohl als stand-alone-Vorrichtung oder aber innerhalb einer Fertigungslinie eingesetzt werden. Im Linienverbund kann der Bestückautomat 1 dabei in eine gemeinsame Substrat-Transporteinrichtung integriert oder an ein eigenes gemeinsames Transportsystem 4 der Fertigungslinie angebunden werden. Zur Steuerung des Bestückautomaten 1 im stand-alone Betrieb ist eine lokale Steuereinrichtung 20 vorgesehen. Im Fertigungsverbund ist es möglich, die lokale Steuereinrichtung 20 mit anderen lokalen Steuereinrichtungen oder auch mit einer übergeordneten Liniensteuerung (nicht dargestellt) zu vernetzen.

Mit Hilfe des in den Figuren 2a und 2b dargestellten Bestückautomaten 1 ist es möglich, ein Substrat 2 streifenweise zu bestücken. Hierunter ist zu verstehen, dass mehrere Bauelemente 3 auf ihren vordefinierten Bestückpositionen innerhalb eines Streifens S des Substrats 2 abgesetzt werden können, ohne dass hierzu das Substrat 2 in y-Richtung verfahren werden muss. Die Positionierung des jeweils abzusetzenden Bauelements 3 relativ zu seiner Bestückposition auf dem Substrat 2 in y-Richtung erfolgt durch eine geeignete Bewegung der betreffenden Halteeinrichtung 8 am Bestückkopf 6, im dargestellten Fall durch eine Drehung des Rotors 13 um die Drehachse 12. Eventuell erforderliche Lagekorrekturen in x-Richtung erfolgen durch ein Verschieben des jeweiligen Bestückkopfs 6 entlang der zugeordneten Führungselemente 9.

Damit kann jeder der beiden Bestückköpfe 6 einen Streifen S auf dem Substrat 2 autark bestücken, ohne dabei den anderen Bestückkopf 6 zu behindern. Sind die Führungselemente 9 der beiden Bestückköpfe 6 entsprechend eng aneinander angeordnet, so ist es mittels dieser Anordnung möglich, einen streifenförmigen Abschnitt, welcher ungefähr doppelt so breit ist wie der Durchmesser eines Bestückkopfs 6, abzüglich eines Sicherheitsabstands zwischen den beiden Bestückköpfen 6, vollständig zu bestücken, ohne dabei das Positioniersystem 7 oder das Substrat 2 verfahren zu müssen. Erst nach einer vollständigen Bestückung der den Bestückköpfen 6 zugeordneten Streifen S ist ein Weitertakten des Substrats 2 in y-Richtung erforderlich.

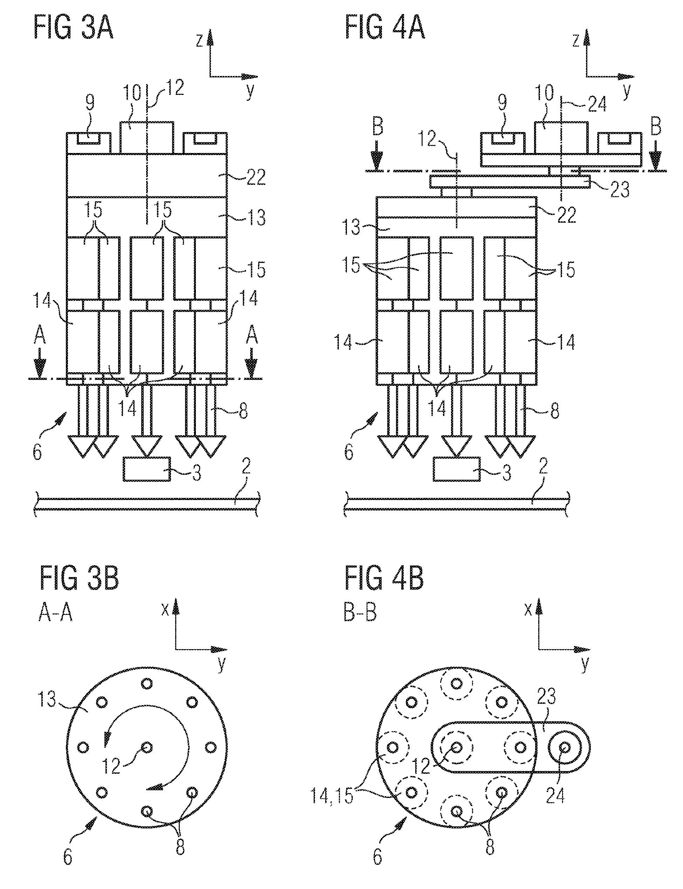

In den Figuren 3 bis 5 sind mehrere Konzepte für die konstruktive Gestaltung des Bestückkopfs 6 dargestellt, welche sich für eine streifenweise Bestückung eines Substrats 2 eignen.

Die Figuren 3a und 3b zeigen eine Ausführungsform des Bestückkopfs 6 als Revolverkopf in Grund- und Aufriss. Der Revolverkopf 6 ist rotationssymmetrisch aufgebaut und weist einen Stator 22 sowie einen Rotor 13 auf, welcher um eine Drehachse 12 drehbar am Stator 22 gelagert ist. Ferner sind am Stator 22 Führungselemente 9 sowie Teile einer Antriebseinheit 10 angeordnet, mit denen der Bestückkopf 6 an einem Positioniersystem 7 (siehe Figuren 1 und 2) verfahrbar angebracht werden kann. Am Rotor 13 sind mehrere Halteeinrichtungen 8 äquidistant auf einer Kreisbahn angeordnet, deren Mittelpunkt die Drehachse 12 bildet. Die Halteeinrichtungen 8 sind zur Handhabung von Bauelementen 3 vorgesehen und verfügen jeweils über einen eigenen Drehantrieb 14 sowie über einen eigenen z-Antrieb 15. Während die Drehantriebe 14 zur Korrektur der Winkellage des jeweils gehaltenen Bauelements 3 um die z-Achse ausgebildet sind, kann mit Hilfe des jeweiligen z-Antriebs eine Zustellbewegung der jeweiligen Halteeinrichtung 8 in z-Richtung durchgeführt werden.

Nachdem bei der streifenweisen Bestückung weder das Substrat 2 noch das Positioniersystem 7 verfahren werden, erfolgt eine x/y-Positionierung der gehaltenen Bauelemente 3 über ihren Bestückpositionen auf dem Substrat 2 durch eine Verfahrbewegung des Revolverkopfs 6 in x-Richtung sowie eine Rotationsbewegung des Rotors 13 um die Drehachse 12. Durch die Rotationsbewegung der Halterichtungen 8 entsteht in Bezug zum Substrat 2 eine zusätzliche y-Achse, mit deren Hilfe die Positionierung in y-Richtung erfolgt. Eine ggf. notwendige Korrektur der x-Koordinate wird mittels einer Verfahrbewegung des Revolverkopfs 6 entlang des Positioniersystems 7 ermöglicht.

Die Figuren 4a und 4b zeigen eine weitere Ausführungsform des Bestückkopfs 6 als Revolverkopf in Grund- und Aufriss. Prinzipiell entspricht der Aufbau des hier dargestellten Revolverkopfs 6 dem des in den Figuren 3a und 3b dargestellten Bestückkopfs: Der Revolverkopf 6 weist wiederum einen Rotor 13 auf, an dem mehrere Halteeinrichtungen 8 kreisförmig angeordnet sind. Jede der Halteeinrichtungen 8 verfügt über einen eigenen Drehantrieb 14 zur Korrektur der Winkellage sowie einen eigenen z-Antrieb 15 für die Zustellbewegung der jeweiligen Halteeinrichtung in z-Richtung. Zusätzlich weist der hier dargestellte Revolverkopf 6 eine Schwenkachse 24 sowie einen um diese Schwenkachse 24 schwenkbaren Schwenkarm 23 auf, an dem der Rotor 13 des Revolverkopfs 6 drehbar gelagert ist. Die Schwenkachse 24 ist dabei ebenso wie die Drehachse 12 des Revolverkopfs senkrecht zur Ebene des Substrats 2 in z-Richtung orientiert. Führungselemente 9 und Antriebseinheit 10 sind in diesem Fall nicht direkt am Stator 22 des Revolverkopfs 6, sondern auf Seite des Schwenkmechanismus angeordnet. Mit Hilfe der zusätzlichen Schwenkachse 24 sowie des Schwenkarms 23 ist es möglich, den Aktionskreis des Revolverkopfs und damit die Breite des bestückbaren Streifens S auf dem Substrat 2 deutlich zu vergrößern.

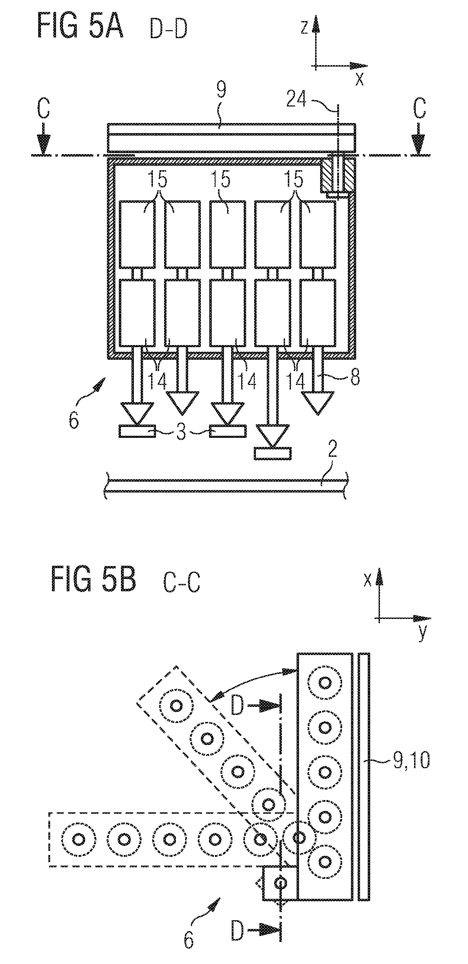

Die Figuren 5a und 5b zeigen eine weitere Ausführungsform des Bestückkopfs 6 in Grund- und Aufriss. Diese Ausführungsform ist als Zeilenkopf ausgebildet und weist ebenfalls eine Schwenkachse 24 auf, welche vorzugsweise in einem Endbereich des Zeilenkopfs 6 angeordnet ist und eine Drehung des Zeilenkopfs 6 um zumindest 90° erlaubt.

Zeilenköpfe zeichnen sich dadurch aus, dass die einzelnen Halteeinrichtungen 8 entlang einer geraden Linie parallel zueinander angeordnet sind. Im dargestellten Fall weist der Kopf 6 fünf Halteeinrichtungen 8 auf, welche wiederum jeweils über einen eigenen Drehantrieb 14 sowie einen eigenen z-Antrieb 15 verfügen. Die Halteeinrichtungen 8 sowie die zugeordneten Dreh- und z-Antriebe 14 und 15 sind zu einer baulichen Einheit zusammengefasst, welche um die Schwenkachse 24 drehbar ist. Die Schwenkachse 24 ist dabei an einem stationären Teil des Bestückkopfs 6 angeordnet und mit Hilfe von Führungs- und Antriebselementen 9, 10 an einem Positioniersystem 7 (siehe Figuren 1 und 2) in x-Richtung verfahrbar. Auch mit Hilfe dieses schwenkbaren Matrixkopfs 6 ist es möglich, bei ruhendem Substrat 2 und festgehaltenem Positioniersystem 7 einen Streifen S des Substrats 2 vollständig zu bestücken, indem die Positionierung in y-Richtung durch die Schwenkbewegung und die x- Positionierung durch eine Verfahrbewegung des Bestückkopfes 6 erfolgt.

Prinzipiell ist es für die streifenweise Bestückung ebenso möglich, Bestückköpfe 6 zu verwenden, welche über einen gemeinsamen Drehantrieb und/oder einen gemeinsamen z-Antrieb verfügen, welche jeweils mit einer der Halteeinrichtungen 8 koppelbar sind. Die Flexibilität hinsichtlich einer möglichen Vorpositionierung der Winkellage bzw. der Zustellbewegung in z-Richtung wird dadurch allerdings eingeschränkt.

Weiterhin ist es zur Erhöhung der Bestückleistung möglich, mehrere Bestückköpfe 6 gemeinsam auf einem Schlitten anzuordnen und in x-Richtung mittels einer gemeinsamen Antriebseinheit 10 sowie gemeinsamen Führungselementen 9 zu verfahren. Die zusätzlichen Bestückköpfe 6 können dabei mit einem separaten Antrieb ausgestattet sein, mit dem sie in x-Richtung relativ zum Schlitten verfahrbar sind. Damit ist eine Entkopplung der Bewegungen möglich, so dass auch die mehreren an einem gemeinsamen Schlitten angeordneten Bestückköpfe 6 relativ unabhängig voneinander Bauelemente 3 auf dem Substrat 2 positionieren können. Werden mehrere schwenkbare Revolverköpfe (siehe Figuren 4a und 4b) oder Matrixköpfe (siehe Figuren 5a und 5b) an einem gemeinsamen Schlitten angeordnet, so ist darauf zu achten, dass durch die Schwenkbewegung keiner der benachbart angeordneten Bestückköpfe 6 behindert wird.

Anhand der Figuren 2a und 2b wird im Folgenden das erfindungsgemäße Verfahren der streifenweisen Bestückung näher erläutert. Dabei soll zunächst lediglich einer der beiden dargestellten Bestückköpfe 6 betrachtet werden.

Zunächst wird der Bestückkopf 6 in x-Richtung in einen Abholbereich verfahren, in dem die Bauelemente mit Hilfe von Zuführeinrichtungen 5 bereitgestellt werden. Dort werden mittels der am Rotor 13 des Bestückkopfs 6 angeordneten Halteeinrichtungen 8 die Bauelemente 3 von Abholpositionen 17 der Zuführeinrichtungen 5 abgeholt. Die Positionierung der jeweiligen Halteeinrichtung 8 über der zugeordneten Abholposition 17 erfolgt durch eine Drehbewegung des Rotors 13 um die Rotor-Drehachse 12, sowie eine Verfahrbewegung des Bestückkopfs 6 in x-Richtung. Die beiden Bewegungen können dabei zeitlich überlagert ausgeführt werden. Mittels einer Zustellbewegung der Halteeinrichtung 8 in z-Richtung kann das Bauelement 3 anschließend aufgenommen werden kann. Entspricht der Abstand der Abholpositionen 17 zweier abzuholender Bauelemente 3 dem Abstand der zur Abholung vorgesehenen Halteeinrichtungen 8, so ist es auch möglich, zwei Bauelemente 3 gleichzeitig abzuholen. Im Falle von Zeilenköpfen wäre es auch denkbar, mehr als zwei Bauelemente 3 gleichzeitig abzuholen.

Anschließend verfährt der Bestückkopf 6 mit den aufgenommenen Bauelementen 3 in x-Richtung über das Substrat 2, auf dem die Bauelemente 3 auf vordefinierten Bestückpositionen abgesetzt werden sollen. An dieser Stelle sei nochmals darauf hingewiesen, dass das Positioniersystem 7 in dem in den Figuren 2a und 2d dargestellten Ausführungsbeispiel nicht verfahrbar ausgebildet ist, sondern ausschließlich der linearen Bewegung eines oder mehrerer Bestückköpfe 6 in x-Richtung dient und daher mit dem Maschinengrundkörper 16 des Bestückautomaten 1 fest verbunden ist. Im Falle eines x/y-Positioniersystems zum Positionieren des Bestückkopfs 6 sowohl in der x- wie auch in der y-Richtung (siehe Figur 1), bewegt sich dem erfindungsgemäßen Verfahren zufolge ebenfalls lediglich der Bestückkopf 6 in x-Richtung, währenddessen das Positioniersystem 7 ortsfest ruht.

Das Substrat 2 kann mit Hilfe eines Schlittens 21, welcher der Substrat-Transporteinrichtung 11 zugeordnet und entlang einer y-Richtung verfahrbar ist, derart positioniert werden, dass der Bestückkopf 6 beim Verfahren in x-Richtung einen streifenartigen Teilbereich des Substrats 2 überdeckt. In dieser Position bleibt das Substrat 2 während der vollständigen Bestückung des Streifens S fixiert. Die Breite des Streifens S entspricht dabei ungefähr dem doppelten Abstand einer Halteeinrichtung 8 zur Drehachse. Die Positionierung des Substrats 2 in y-Richtung erfolgt vorteilhafter Weise während der Bestückkopf 6 Bauelemente 3 von den Abholpositionen 17 aufnimmt.

Die Positionierung eines abzusetzenden Bauelements 3 über seiner zugeordneten Bestückposition auf dem Substrat 2 erfolgt wiederum mittels einer eine Drehbewegung des Rotors 13 um die Rotor-Drehachse 12, sowie eine Verfahrbewegung des Bestückkopfs 6 in x-Richtung, wobei die beiden Bewegungen wiederum zeitlich überlagert ausgeführt werden können. Durch eine Zustellbewegung der jeweiligen Halteeinrichtung 8 in z-Richtung kann das betreffende Bauelement 3 auf seiner Bestückposition auf dem Substrat 2 abgesetzt werden. Entspricht der Abstand zweier Bestückpositionen zweier abzusetzender Bauelemente 3 dem Abstand der die Bauelemente 3 haltenden Halteeinrichtungen 8, so ist es auch möglich, zwei Bauelemente 3 gleichzeitig auf dem Substrat 2 abzusetzen.

Sind innerhalb eines Streifens S mehrere Bauelemente 3 zu positionieren, als der Bestückkopf 6 auf einmal aufnehmen kann, so wird der Bestückkopf 6 erneut in den Abholbereich gefahren, um Bauelemente 3 aufzunehmen, um sie anschließend wieder auf dem Substrat 2 zu positionieren. Dieses Procedere wiederholt sich so lange, bis der bestückbare Streifen S des Substrats 2 vollständig mit Bauelementen bestückt ist.

Anschließend wird das Substrat 2 mittels des Schlittens 21 in y-Richtung um ca. eine Streifenbreite weiter transportiert, so dass ein weiterer Streifen S des Substrats 2 bestückt werden kann. Falls der Bestückautomat 1 über ein x/y-Positioniersystem 7 verfügt, mit dem der Bestückkopf sowohl in der x- als auch in der y-Richtung positioniert werden kann, so kann der Wechsel auf einen benachbarten Streifen S auch durch ein Verfahren des Positioniersystems 7 in der y-Richtung statt durch eine Positionierbewegung des Substrats 2 erfolgen.

Wenn - wie in den Figuren 2a und 2b dargestellt - der Bestückautomat 1 über mehrere Bestückköpfe 6 verfügt, welche parallel zueinander in x-Richtung verfahrbar sind, so kommen hierfür mehrere Betriebsmodi in Frage: Zum einen können die beiden Bestückköpfe 6 wechselweise betrieben werden, d.h. während der eine Bestückkopf 6 im Abholbereich Bauelemente 3 aufnimmt, bestückt der andere Bestückkopf 6 einen ihm zugewiesenen Streifen S des Substrats 2 mit Bauelementen. Zum anderen können die Bestückköpfe 6 simultan betrieben werden, d.h. beide Bestückköpfe 6 holen gemeinsam Bauelemente 3 von den ihnen jeweils zugeordneten Abholpositionen 17 ab und bestücken anschließend gemeinsam jeweils einen ihnen zugewiesenen Streifen S des Substrats 2. Dabei bleibt zwischen den beiden benachbarten Streifen S in der Regel ein schmaler Bereich als Sicherheitsabstand zwischen den Bestückköpfen 6 frei. Dieser kann gegebenenfalls in einem späteren Schritt mit Bauelementen 3 bestückt werden. Da sich die Bestückköpfe 6 bei der Bestückung des ihnen zugewiesenen Streifens S in keiner Weise beeinflussen ist es ferner ebenso möglich, die Bestückköpfe 6 völlig unabhängig voneinander zu betreiben. Lediglich beim Weitertakten des Substrats 2 in y-Richtung müssen die Bestückköpfe 6 hinsichtlich ihrer Verfahrwege koordiniert werden.

Ferner ist es möglich, beim Verfahren eines Bestückkopfs 6 zwischen dem Abholbereich und dem Substrat 2 einen Sensor anzuordnen, mit dem beispielsweise die Lage eines Bauelementes 3 relativ zu der jeweiligen Halteeinrichtung 8 zu erfassen.

Werden anstelle der dargestellten Rotationsköpfe Zeilenköpfe (vgl. Figuren 5a/5b) eingesetzt, so wird die y-Positionierung eines abzusetzenden Bauelements 3 über dem Substrat 2 mittels einer Schwenkbewegung des Zeilenkopfes anstelle der Drehbewegung realisiert. Gleiches gilt für den in den Figuren 4a/4b dargestellten schwenkbaren Revolverkopf.

### Bezugszeichenliste

- 1: Bestückautomat
- 2: Substrat
- 3: Bauelement
- 4: Transportsystem
- 5: Zuführeinrichtung
- 6: Bestückkopf
- 7: Positioniersystem
- 8: Halteeinrichtung
- 9: Führungselement
- 10: Antriebseinheit
- 11: Substrat-Transporteinrichtung
- 12: Drehachse
- 13: Rotor
- 14: Drehantrieb
- 15: z-Antrieb
- 16: Maschinen-Grundkörper
- 17: Abholposition
- 18: Standfuß
- 19: Transportrollen
- 20: Steuereinrichtung
- 21: Schlitten
- 22: Stator
- 23: Schwenkarm
- 24: Schwenkachse
- S: Streifen des Substrats

## Patentansprüche

1. Verfahren zum Bestücken von Substraten (2) mit Bauelementen (3) für einen Bestückautomaten (1),
wobei der Bestückautomat (1) umfasst:
- einen Maschinengrundkörper (16),
- ein Positioniersystem (7) zur Aufnahme mindestens eines Bestückkopfs (6), welches am Maschinengrundkörper (16) angeordnet ist,
- einen ersten Bestückkopf (6) zum Handhaben der Bauelemente (3), welcher an dem Positioniersystem (7) in einer x-Richtung verfahrbar angeordnet ist,
- mindestens zwei Halteeinrichtungen (8), welche jeweils zum Halten eines der Bauelemente (3) an dem ersten Bestückkopf (6) in einer Ebene parallel zur Ebene des Substrats (2) angeordnet sind,
**dadurch gekennzeichnet,**
- **dass** mindestens zwei Bauelemente (3) auf vordefinierte Bestückpositionen des Substrats (2) bestückt werden,
- wobei während der Positionierung der mindestens zwei Bauelemente (3) das Substrat (2) sowie das Positioniersystem (7) relativ zum Maschinen-Grundkörper (16) ruhen, und
- wobei die Bestückpositionen der mindestens zwei Bauelemente (3) sich innerhalb eines zu bestückenden Streifens (S) des Substrats (2) befinden und einen unterschiedlichen Abstand zu einer senkrechten Projektion der Verfahrachse des Bestückkopfs (6) auf das Substrat (2) aufweisen.

2. Verfahren nach Anspruch 1,
**dadurch gekennzeichnet,**
- **dass** das Substrat (2) nach dem Bestücken eines Streifens (S) des Substrats (2) mit Bauelementen (3) relativ zum Maschinengrundkörper (16) fixiert bleibt und
- **dass** das Positioniersystem (7) in einer y-Richtung um eine definierte Länge weitergefahren wird, so dass ein weiterer Streifen des Substrats (2) bestückt werden kann.

3. Verfahren nach Anspruch 1,
**dadurch gekennzeichnet,**
- **dass** der Bestückautomat (1) ferner eine Substrat-Transporteinrichtung (11) umfasst,
- **dass** nach dem Bestücken eines Streifens (S) des Substrats (2) mit Bauelementen (3) das Substrat (2) mittels der Substrat-Transporteinrichtung (11) in einer y-Richtung um eine definierte Länge weitergefahren wird, während das Positioniersystem (7) relativ zum Maschinen-Grundkörper (16) fixiert bleibt, so dass ein weiterer Streifen (S) des Substrats (2) bestückt werden kann.

4. Verfahren nach einem der Ansprüche 1 bis 3,
**dadurch gekennzeichnet,**
- **dass** die Bauelemente (3) mittels Zuführeinrichtungen (5) des Bestückautomaten (1) bereitgestellt werden und
- **dass** die Bauelemente (3) vor dem Bestücken des Substrats (2) durch den Bestückkopf (6) von den Zuführeinrichtungen (5) abgeholt werden.

5. Verfahren nach einem der Ansprüche 1 bis 4,
**dadurch gekennzeichnet,**
- **dass** an dem Positioniersystem (7) ein weiterer Bestückkopf (6) angeordnet ist,
- **dass** jedem der beiden Bestückköpfe (6) eine eigene Antriebseinheit (10) zugeordnet ist, mittels derer die beiden Bestückköpfe (6) unabhängig voneinander am Positioniersystem (7) verfahren werden können.

6. Verfahren nach Anspruch 5,
**dadurch gekennzeichnet,**
- **dass** die beiden Bestückköpfe (6) an verschiedenen Seiten des Positioniersystems (7) angeordnet sind, und
- **dass** einer der beiden Bestückköpfe (6) das Substrat (2) streifenweise bestückt, während der andere der beiden Bestückköpfe (6) Bauelemente (3) von den Zuführeinrichtungen (5) des Bestückautomaten (1) abholt.

7. Verfahren nach einem der Ansprüche 4 bis 6,
**dadurch gekennzeichnet,**
**dass** der Bestückkopf (6) derart über den Zuführeinrichtungen (5) positioniert wird, dass mittels der mindestens zwei Halteeinrichtungen (8) des Bestückkopfs (6) mehrere Bauelemente (3) gleichzeitig abgeholt werden.

8. Verfahren nach einem der Ansprüche 1 bis 7,
**dadurch gekennzeichnet,**
- **dass** der Bestückautomat (1) an ein Transportsystem (4) zur Versorgung des Bestückautomaten (1) mit zu bestückenden Substraten (2) angeschlossen ist, und
- **dass** ein fertig bestücktes Substrat (2) an das Transportsystem (4) übergeben wird.

9. Bestückautomat (1) zur Durchführung eines Verfahrens nach einem der Ansprüche 1 bis 8, mit
- einem Maschinengrundkörper (16),
- einem Positioniersystem (7) zur Aufnahme mindestens eines Bestückkopfs (6), welches am Maschinengrundkörper (16) angeordnet ist,
- einem ersten Bestückkopf (6) zum Handhaben der Bauelemente (3), welcher an dem Positioniersystem (7) in einer x-Richtung verfahrbar angeordnet ist,
- mindestens zwei Halteeinrichtungen (8), welche zum Halten der Bauelemente (3) an dem ersten Bestückkopf (6) in einer Ebene parallel zu einer Ebene des Substrats (2) angeordnet sind,
**dadurch gekennzeichnet,**
**dass** ein relativ zum Maschinen-Grundkörper (16) ruhendes Substrat (2) bei einem relativ zum Maschinen-Grundkörper (16) festgehaltenem Positioniersystem (7) zumindest streifenweise bestückbar ist.

10. Bestückautomat (1) nach Anspruch 9,
**dadurch gekennzeichnet,**
**dass** der Bestückautomat (1) ferner einer Steuereinrichtung (17) zur Steuerung des Bestückkopfs 6 aufweist.

11. Bestückautomat (1) nach einem der Ansprüche 9 oder 10,
**dadurch gekennzeichnet,**
**dass** das Positioniersystem (7) als feststehendes Portal ausgebildet ist, welches fest mit dem Grundkörper (16) verbunden ist.

12. Bestückautomat (1) nach einem der Ansprüche 9 bis 11,
**dadurch gekennzeichnet,**
**dass** mindestens ein weiterer Bestückkopf (6) an dem Positioniersystem (7) in der x-Richtung verfahrbar angeordnet ist.

13. Bestückautomat (1) nach Anspruch 12,
**dadurch gekennzeichnet,**
**dass** die mindestens zwei Bestückköpfe (6) an unterschiedlichen Führungselementen 9 des Positioniersystems (7) anordenbar sind.

14. Bestückautomat (1) nach einem der Ansprüche 12 oder 13,
**dadurch gekennzeichnet,**
**dass** mehrere Bestückköpfe (6) an derselben Seite des Positioniersystems (7) anordenbar sind und ein gemeinsames Führungselement (9) aufweisen.

15. Bestückautomat (1) nach einem der Ansprüche 12 bis 15,
**dadurch gekennzeichnet,**
**dass** jedem der Bestückköpfe (6) eine eigene Antriebseinheit (10) zugeordnet ist, welche eine voneinander unabhängige Bewegung der Bestückköpfe (6) am Positioniersystem (7) ermöglichen.

16. Bestückautomat (1) nach einem der Ansprüche 9 bis 15,
**dadurch gekennzeichnet,**
**dass** jede Halteeinrichtung (8) einen eigenen, separat ansteuerbaren z-Antrieb (15) aufweist, welcher eine Bewegung der jeweiligen Halteeinrichtungen (8) in einer z-Richtung senkrecht zur Ebene des Substrats (2) ermöglicht.

17. Bestückautomat (1) nach einem der Ansprüche 9 bis 16,
**dadurch gekennzeichnet,**
**dass** jeder der Halteeinrichtungen (8) ein eigener, separat ansteuerbarer Drehantrieb (14) zugeordnet ist, welcher eine Drehbewegung der jeweiligen Halteeinrichtung (8) um eine Achse senkrecht zur Ebene des Substrats (2) ermöglicht.

18. Bestückautomat (1) nach einem der Ansprüche 9 bis 17,
**dadurch gekennzeichnet,**
**dass** zumindest einer der Bestückköpfe (6) eine zusätzliche Drehachse (12) zum Drehen des Bestückkopfs (6) aufweist, wobei die Drehachse (12) senkrecht zur Ebene des Substrats (2) orientiert ist, so dass mittels der mindestens zwei Halteeinrichtungen (8) des Bestückkopfs (6) Bewegungen in einer Ebene parallel zur Ebene des Substrats (2) ausführbar sind.

19. Bestückautomat (1) nach Anspruch 18,
**dadurch gekennzeichnet,**
**dass** der Bestückkopf (6) einen um die Drehachse (12) drehbaren Rotor (11) aufweist, an dem die mindestens zwei Halteeinrichtungen (8) angeordnet sind.

20. Bestückautomat (1) nach Anspruch 18,
**dadurch gekennzeichnet,**
**dass** die Drehachse (12) als Schwenkachse (24) ausgebildet ist, welche außermittig am Bestückkopf (6) angeordnet ist, so dass der Bestückkopf (6) um die Schwenkachse (24) schwenkbar ist.
